# FASCICULE DE BREVET EUROPEEN

(11) **EP 3 450 841 B1**
(45) Date de publication et mention de la délivrance du brevet: **07.04.2021**
(21) Numéro de dépôt: 18187362.1
(22) Date de dépôt: 03.08.2018
(51) Int. Cl.: F21V 23/00, F21S 41/141, F21S 43/14, F21Y 115/10

(54) **DISPOSITIF LUMINEUX POUR VEHICULE AUTOMOBILE**
LEUCHTMODUL FÜR KRAFTFAHRZEUG
LIGHT DEVICE FOR A MOTOR VEHICLE

(30) Priorité: 05.09.2017 FR 1758190
(43) Date de publication de la demande: 06.03.2019
(73) Titulaire: Valeo Vision, 93012 Bobigny Cedex (FR)
(72) Inventeur: ZHU, Lingxuan, 93012 Bobigny Cedex (FR); MECHMECHE, Haifa, 93012 Bobigny Cedex (FR); MILLON, Franck, 93012 Bobigny Cedex (FR); MERLIN, Cedric, 93012 Bobigny Cedex (FR); KRICK, Sebastian, 93012 Bobigny Cedex (FR)
(74) Mandataire: Valeo Visibility

(56) Documents cités:
- EP-A1- 3 073 182
- WO-A1-2005/027598
- WO-A2-03/066374
- GB-A- 2 484 152
- JP-A- 2012 018 865
- US-A1- 2013 039 063

## Description

### DOMAINE TECHNIQUE DE L'INVENTION

La présente invention concerne un dispositif lumineux pour véhicule automobile.

Elle trouve une application particulière dans les dispositifs d'éclairage et/ou de signalisation pour véhicule automobile.

### ARRIÈRE-PLAN TECHNOLOGIQUE DE L'INVENTION

Un dispositif lumineux pour véhicule automobile comprend de manière connue de l'homme du métier :
- au moins une source lumineuse ;
- au moins un composant électronique de pilotage de l'alimentation électrique de ladite au moins une source lumineuse ;
- une platine support comprenant un substrat avec au moins une languette sur laquelle sont disposés :
   - ladite au moins une source lumineuse sur une première face de ladite languette ;
   - ledit au moins un composant électronique de pilotage sur une deuxième face de ladite languette opposée à ladite première face.

Un inconvénient de cet état de la technique est que la chaleur dégagée par la source lumineuse peut impacter thermiquement le composant électronique de pilotage. Ceci peut perturber le fonctionnement dudit composant électronique de pilotage. De la même manière, la chaleur dégagée par le composant électronique de pilotage peut également impacter thermiquement la source lumineuse et perturber le fonctionnement de ladite source lumineuse.

Dans ce contexte, la présente invention vise à résoudre l'inconvénient précédemment mentionné.

Le document WO 2005/027598 A1 divulgue un dispositif lumineux pour véhicule automobile comprenant un substrat avec des languettes pour la fixation des sources lumineuses.

### DESCRIPTION GENERALE DE L'INVENTION

A cette fin l'invention propose un dispositif lumineux pour véhicule automobile, ledit dispositif lumineux comprenant :
- au moins une source lumineuse ;
- au moins un composant électronique de pilotage de l'alimentation électrique de ladite au moins une source lumineuse ;
- une platine support comprenant un substrat rigide avec :
   - une languette primaire sur laquelle est disposée ladite au moins une source lumineuse ;
   - une languette secondaire sur laquelle est disposé ledit au moins un composant électronique de pilotage, ladite languette secondaire étant différente de ladite languette primaire,
ledit substrat présentant une courbure, ladite languette primaire et ladite languette secondaire présentant une ligne de découpe qui part et finit d'une base, la base formant la jonction entre une languette primaire ou secondaire et le substrat rigide, la surface de la languette primaire et secondaire étant tangente à la surface du substrat rigide à l'endroit de la base.

Ainsi, comme on va le voir en détail ci-après, le fait de positionner la source lumineuse et le composant électronique de pilotage sur deux languettes différentes permet de les isoler l'un de l'autre de sorte que la chaleur que le composant électronique de pilotage génère n'ait pas d'influence sur la source lumineuse et vice et versa. Le fonctionnement de la source lumineuse et du composant électronique de pilotage n'est ainsi pas dégradé.

Selon des modes de réalisation non limitatifs, le dispositif lumineux peut comporter en outre une ou plusieurs caractéristiques supplémentaires parmi les suivantes :
Selon un mode de réalisation non limitatif, la languette primaire et/ou la languette secondaire comprend une ligne de découpe dont un côté est confondu avec la périphérie dudit substrat.
Selon un mode de réalisation non limitatif, la languette primaire et/ou la languette secondaire comprend une ligne de découpe :
   - avec des segments droits ; ou
   - en forme courbée.
Selon un mode de réalisation non limitatif, la languette primaire et/ou la languette secondaire comprend une ligne de découpe comprenant trois côtés qui sont à distance de la périphérie dudit substrat.
Selon un mode de réalisation non limitatif, la languette primaire et/ou la languette secondaire comprend une ligne de découpe :
   - en forme de U ; ou
   - en forme de trapèze dépourvu d'une de ses bases ; ou
   - en forme courbée.
Selon un mode de réalisation non limitatif, la languette primaire et la languette secondaire sont décalées l'une de l'autre.
Selon un mode de réalisation non limitatif, la languette primaire et la languette secondaire sont disposées côte à côte.
Selon un mode de réalisation non limitatif, ledit dispositif lumineux comprend une pluralité de languettes primaires et une pluralité de languettes secondaires.
Selon un mode de réalisation non limitatif, ladite au moins une source lumineuse est une source lumineuse à semi-conducteur.
Selon un mode de réalisation non limitatif, ladite source lumineuse à semi-conducteur fait partie d'une diode électroluminescente.
Selon un mode de réalisation non limitatif, ledit dispositif lumineux est adapté pour réaliser une fonction d'éclairage et/ou de signalisation.
Selon un mode de réalisation non limitatif, ledit dispositif lumineux est un projecteur avant ou un feu arrière.
Selon un mode de réalisation non limitatif, ledit dispositif lumineux est :
   - un clignotant ; et/ou
   - un feu diurne ; et/ou
   - un feu de parking ; et/ou
   - un feu de position ; et/ou
   - un feu d'arrêt ; et/ou
   - un feu de recul ; et/ou
   - un feu de brouillard ; et/ou
   - un feu latéral ; et/ou
   - un troisième feu de stop.
Selon un mode de réalisation non limitatif, une unique source lumineuse est disposée sur ladite au moins une languette primaire. La chaleur dégagée par une source lumineuse ne peut ainsi pas impacter une autre source lumineuse.
Selon un mode de réalisation non limitatif, une pluralité de sources lumineuses est disposée sur ladite au moins une languette primaire. La chaleur dégagée par un groupe de sources lumineuses ne peut ainsi pas impacter un autre groupe de sources lumineuses.
Selon un mode de réalisation non limitatif, un unique composant électronique de pilotage est disposé sur ladite au moins une languette secondaire. La chaleur dégagée par un composant électronique de pilotage ne peut ainsi pas impacter un autre composant électronique de pilotage.
Selon un mode de réalisation non limitatif, une pluralité de composants électroniques de pilotage est disposée sur ladite au moins une languette secondaire. La chaleur dégagée par un groupe de composants électroniques de pilotage ne peut ainsi pas impacter un autre groupe de composants électroniques de pilotage.

### BREVE DESCRIPTION DES FIGURES

L'invention et ses différentes applications seront mieux comprises à la lecture de la description qui suit et à l'examen des figures qui l'accompagnent.

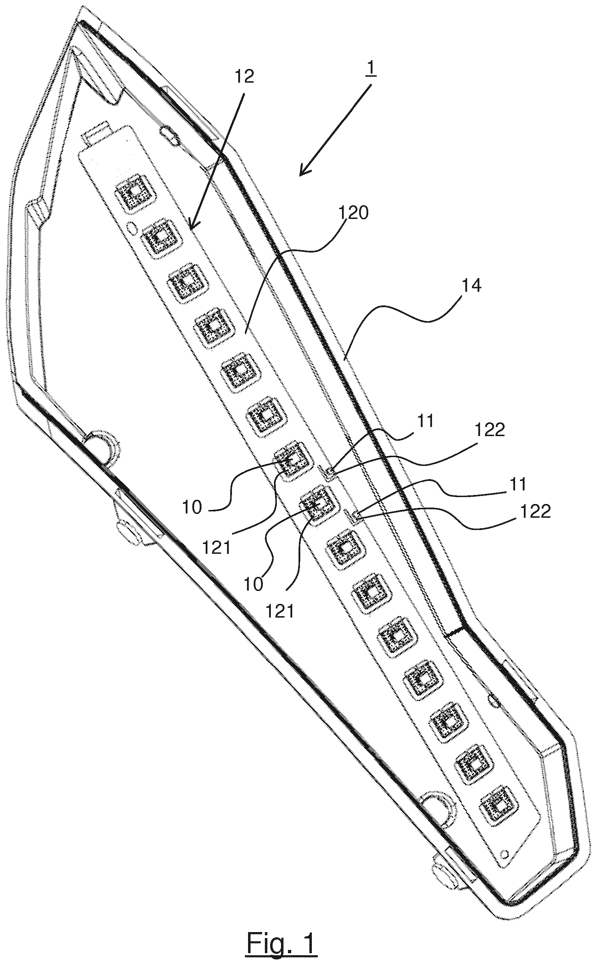

- la figure 1 représente un dispositif lumineux selon un mode de réalisation non limitatif de l'invention, ledit dispositif lumineux comprenant au moins une source lumineuse, au moins un composant électronique de pilotage de l'alimentation électrique de ladite source lumineuse et une platine support avec un substrat ;

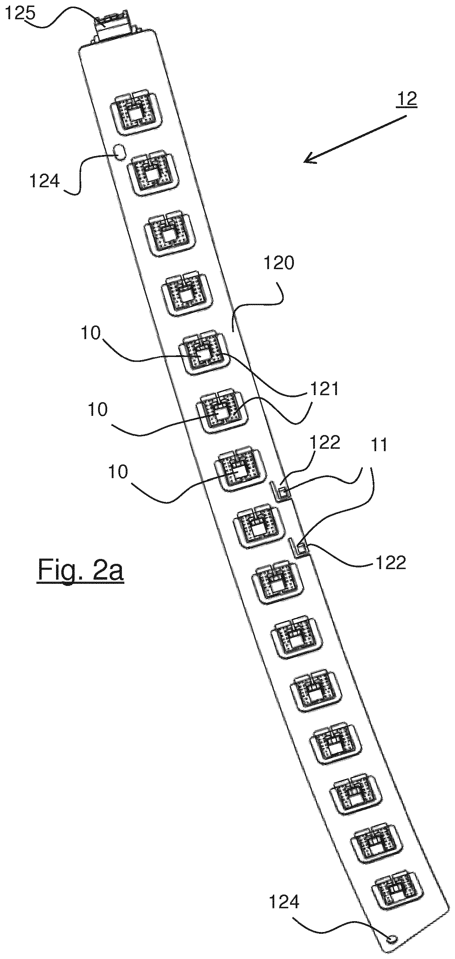

- la figure 2a représente une vue agrandie de ladite platine support de la figure 1, ladite platine support comprenant au moins une languette primaire selon un premier mode de réalisation non limitatif et au moins une languette secondaire selon un deuxième mode de réalisation non limitatif ;

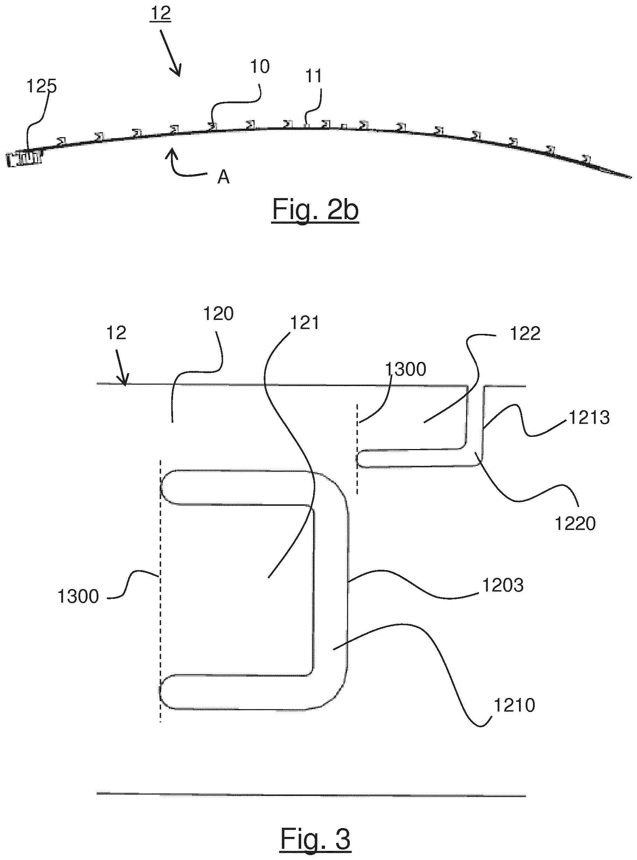

- la figure 2b représente ladite platine support de la figure 2a vue de profil ;
- la figure 3 représente une vue zoomée d'une partie de ladite platine support des figures 2a et 2b, ladite partie comprenant au moins une languette primaire ou secondaire selon un premier mode de réalisation non limitatif et au moins une languette primaire ou secondaire selon un deuxième mode de réalisation non limitatif, les languettes primaires et secondaires étant représentées sans source lumineuse et sans composant électronique de pilotage de l'alimentation électrique de ladite source lumineuse ;

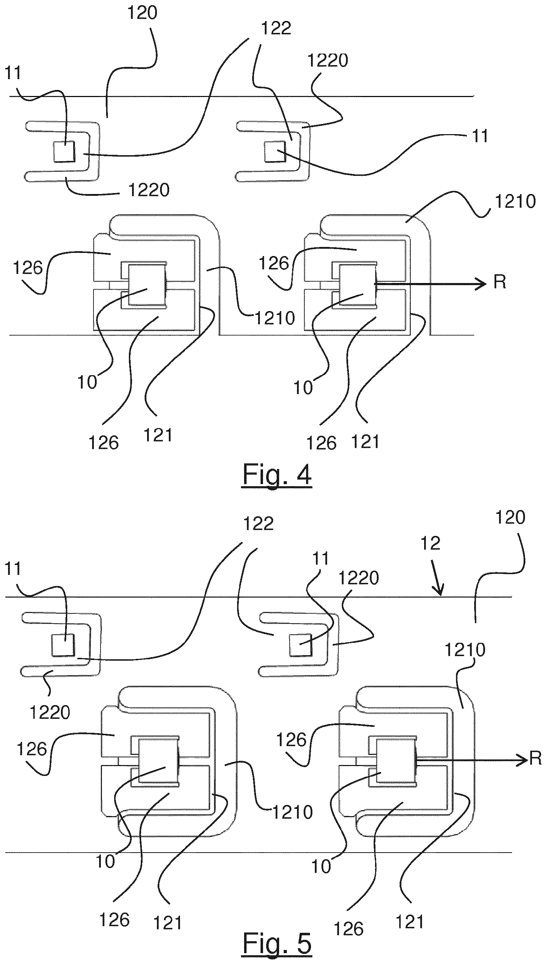

- la figure 4 représente une vue zoomée d'une partie de ladite platine support de la figure 1, comprenant au moins une languette primaire selon un deuxième mode de réalisation non limitatif et au moins une languette secondaire selon un premier mode de réalisation non limitatif, les languettes primaires et secondaires étant décalées l'une de l'autre ;
- la figure 5 représente une vue zoomée d'une partie de ladite platine support de la figure 1, comprenant au moins une languette primaire selon un premier mode de réalisation non limitatif et au moins une languette secondaire selon un premier mode de réalisation non limitatif, les languettes primaires et secondaires étant décalées l'une de l'autre ;

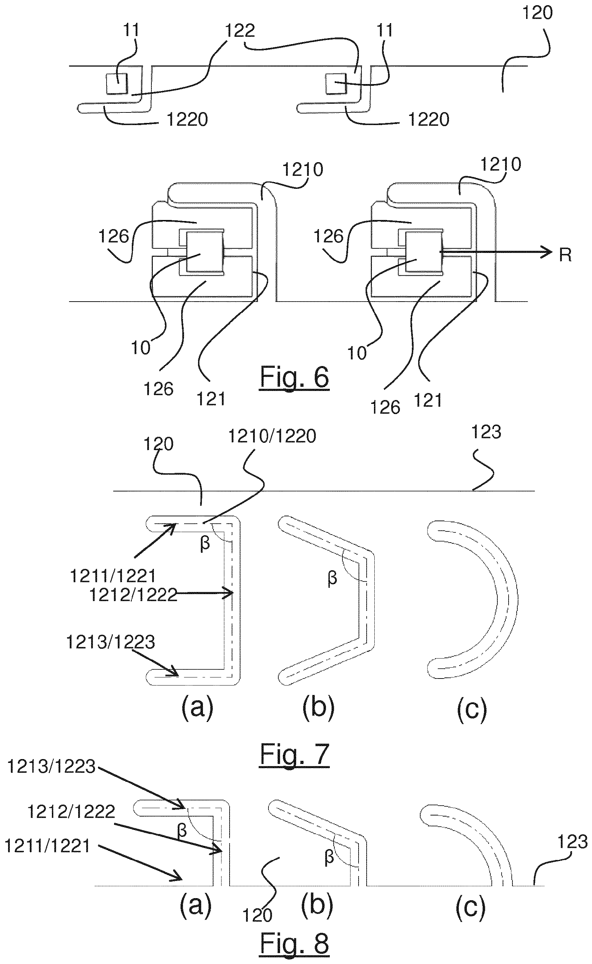

- la figure 6 représente une vue zoomée d'une partie de ladite platine support de la figure 1, comprenant au moins une languette primaire selon un deuxième mode de réalisation non limitatif et au moins une languette secondaire selon un deuxième mode de réalisation non limitatif, les languettes primaires et secondaires étant décalées l'une de l'autre ;
- la figure 7 représente différentes variantes de réalisation non limitatives d'une ligne de découpe de ladite au moins une languette primaire et de ladite au moins une languette secondaire selon le premier mode de réalisation non limitatif des figures 3 à 5 ;
- la figure 8 représente différentes variantes de réalisation non limitatives d'une ligne de découpe de ladite au moins une languette primaire et de ladite au moins une languette secondaire selon le deuxième mode de réalisation non limitatif des figures 3, 4 et 6 ; et

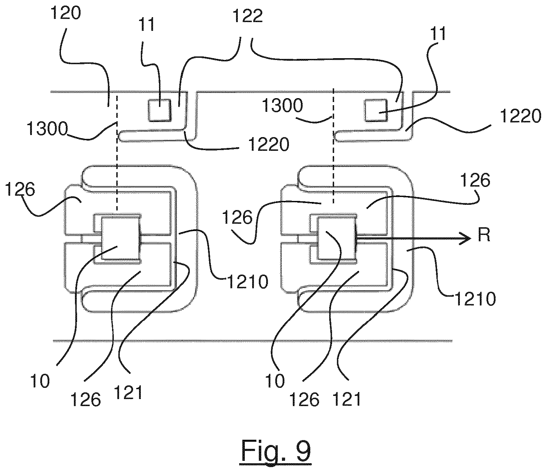

- la figure 9 représente une vue zoomée d'une partie de ladite platine support de la figure 1, comprenant au moins une languette primaire selon un premier mode de réalisation non limitatif et au moins une languette secondaire selon un deuxième mode de réalisation non limitatif, les languettes primaires et secondaires décalées étant remplacées par des languettes primaires et secondaires disposées côte à côte.

### DESCRIPTION DE MODES DE REALISATION DE L'INVENTION

Les éléments identiques, par structure ou par fonction, apparaissant sur différentes figures conservent, sauf précision contraire, les mêmes références.

Le dispositif lumineux 1 pour véhicule automobile selon l'invention est décrit en référence aux figures 1 à 9.

Par véhicule automobile, on entend tout type de véhicule motorisé.

Dans un mode de réalisation non limitatif, le dispositif lumineux 1 est adapté pour réaliser une fonction d'éclairage et/ou de signalisation.

Dans une première variante de réalisation non limitative, le dispositif lumineux 1 est un projecteur avant, ou un feu arrière pour véhicule automobile. Ainsi, la fonction d'éclairage réalisée est un feu de croisement ou un feu de route dans des exemples non limitatifs.

Dans une deuxième variante de réalisation non limitative, lorsque la fonction est une fonction de signalisation, le dispositif lumineux 1 est :
- un clignotant TI appelé en anglais « Turn Indicator » ; et/ou
- un feu diurne DRL appelé en anglais « Daytime Running Lamp » ; et/ou
- un feu de parking PL appelé en anglais « Parking Lamp » ; et/ou
- un feu de position T appelé en anglais « Tail » ; et/ou
- un feu d'arrêt STP appelé en anglais « Stop lamp » ; et/ou
- un feu de recul R appelé en anglais « Reverse » ; et/ou
- un feu de brouillard FG appelé en anglais « Fog lamp » ; et/ou
- un feu latéral SM appelé en anglais « Side marker » ; et/ou
- un troisième feu de stop CHMSL, appelé en anglais « Center High-Mount Stop Light ».

Bien entendu, dans un mode de réalisation non limitatif, le dispositif lumineux 1 peut réaliser les deux fonctions d'éclairage et de signalisation en même temps.

Tel qu'illustré sur la figure 1, le dispositif lumineux 1 comprend :
- au moins une source lumineuse 10 ;
- au moins un composant électronique de pilotage 11 de l'alimentation électrique de ladite au moins une source lumineuse 10 ; et
- une platine support 12.

Par souci de simplification, le composant électronique de pilotage 11 de l'alimentation électrique de ladite au moins une source lumineuse 10 est également appelé dans la description composant électronique de pilotage 11.

La platine support 12 est disposée dans un boîtier 14 du dispositif lumineux 1.

Le dispositif lumineux 1 comprend en outre une glace de protection (non illustrée) adaptée pour fermer le boîtier 14 de sorte à protéger les éléments 10, 11, et 12. Cette glace sert aussi pour l'esthétique du dispositif lumineux 1.

Les éléments du dispositif lumineux 1 sont décrits en détail ci-après.

### • Source lumineuse 10

Ladite au moins une source lumineuse est illustrée sur les figures 1 à 2b, et 4 à 6, et 9.

Une source lumineuse 10 est adaptée pour émettre des rayons lumineux R qui coopèrent avec un ensemble optique (non illustré) du dispositif lumineux 1 pour produire un faisceau lumineux (non illustré).

Dans un mode de réalisation non limitatif, l'ensemble optique comprend un réflecteur et/ou une lentille et/ou un guide de lumière et/ou un collimateur. Un tel ensemble optique étant connu de l'homme du métier, il n'est pas décrit ici. Dans des modes de réalisation non limitatifs, les rayons lumineux R sont sensiblement perpendiculaires ou sensiblement parallèles aux languettes primaires 121 de la platine support 12. Dans l'exemple non limitatif illustré sur les figures, les rayons lumineux R sont sensiblement parallèles.

Dans un mode de réalisation non limitatif, une source lumineuse 10 est une source lumineuse à semi-conducteur, en particulier une puce émettrice semiconductrice. Dans une variante de réalisation non limitative, la source lumineuse à semi-conducteur fait partie d'une diode électroluminescente. Par diode électroluminescente, on entend tout type de diodes électroluminescentes, que ce soit dans des exemples non limitatifs des LED (« Light Emitting Diode »), une OLED (« Organic LED ») ou une AMOLED (« Active-Matrix-Organic LED »), ou encore une FOLED (« Flexible OLED »). Dans un mode de réalisation non limitatif, la source lumineuse 5 est une source lumineuse monochromatique ou RGB (pour « Red, Green, Blue » en anglais) ou RGBW (pour pour « Red, Green, Blue, White » en anglais). Dans un mode de réalisation non limitatif illustré, le dispositif lumineux 1 comprend une pluralité de sources lumineuses 10.

Les sources lumineuses 10 génèrent de la chaleur.

### • Composant électronique de pilotage 11

Le composant électronique de pilotage 11 est illustré sur les figures 1 à 2b, 4 à 6 et 9.

Il est adapté pour piloter l'alimentation électrique de la source lumineuse 10 en fonction d'une consigne de puissance reçue d'une unité électronique (non illustrée) du véhicule automobile. La consigne de puissance est déterminée en fonction de la fonction d'éclairage et/ou de signalisation réalisée par le dispositif lumineux 1. Dans des exemples non limitatifs, le composant électronique de pilotage 11 comprend un ou plusieurs transistors ou un convertisseur DC/DC. Un tel composant électronique de pilotage 11 étant connu de l'homme du métier, il n'est pas décrit en détail ici.

On notera qu'un composant électronique de pilotage 11 peut piloter une seule source lumineuse 10 ou plusieurs sources lumineuses 10.

Dans un mode de réalisation non limitatif illustré, le dispositif lumineux 1 comprend une pluralité de composant électroniques de pilotage 11.

### • Platine support 12

La platine support 12 est illustrée sur les figures 1 à 6 et 9.

Elle est adaptée pour accueillir ladite au moins une source lumineuse 10 et ledit au moins un composant électronique de pilotage 11 associé.

La platine support 12 comprend un substrat 120 et des composants électroniques tels qu'au moins une source lumineuse 10 et au moins un composant électronique de pilotage 11 associé.

Tel qu'illustré sur les figures, dans un mode de réalisation non limitatif, la platine support 12 comprend une pluralité de sources lumineuses 10 et une pluralité de composants électroniques de pilotage 11.

Dans un mode de réalisation non limitatif, la platine support 12 est une carte à circuit imprimé qui comprend les composants électroniques, appelée PCBA « Printed Circuit Board Assembly » en anglais.

La platine support 12 comprend en outre un connecteur électrique 125 adapté pour son alimentation électrique et la communication entre les sources lumineuses 10 et les composants électroniques de pilotage 11 avec une unité électronique (non illustrée) du véhicule automobile. Dans un mode de réalisation non limitatif (non illustré), on peut prévoir que ledit connecteur électrique 125 est positionné sur une languette primaire 121 ou secondaire 122 (décrites plus loin) pour bénéficier de l'absence de contrainte mécanique sur lesdites languettes primaire 121 et secondaire 122.

La platine support 12 comprend en outre au moins un dispositif de fixation 124 au boîtier 14 du dispositif lumineux 1. Dans un exemple non limitatif, le dispositif de fixation 124 est un orifice de fixation adapté pour recevoir une vis de fixation. Dans l'exemple non limitatif illustré sur la figure 1 ou 2a, il y a deux orifices de fixation 124.

### ∘ Substrat 120

Dans un mode de réalisation non limitatif, le substrat 120 est rigide. Ce mode de réalisation est pris comme exemple non limitatif dans la suite de la description.

Dans un exemple non limitatif, le substrat rigide 120 est de type FR4 ou SMI. C'est un substrat rigide peu coûteux.

Le substrat rigide 120 est composé de résine époxy et de tissus de verre qui est revêtu et comprend des pistes conductrices 126 qui relient les composants électroniques dont les sources lumineuses 10 et les composants électroniques de pilotage 11 entre eux. On notera que sur les figures 4 à 6, seules les pistes conductrices 126 pour les sources lumineuses 10 ont été représentées.

On notera que les pistes conductrices 126 ont la propriété de dissiper la chaleur que les composants électroniques dont les sources lumineuses 10 et les composants électroniques de pilotage 11 produisent par conduction ou par rayonnement ou par convection. Dans un mode de réalisation non limitatif, les pistes conductrices 126 sont des pistes cuivrées.

Le substrat rigide 120 est configuré de sorte à tenir dans le boitier 14 et suivre la forme courbée du boîtier 14.

Le substrat rigide 120 est ainsi courbé dans un mode de réalisation non limitatif. Il présente une courbure A. A cet effet, le substrat rigide 120 est adapté pour être déformé pour pouvoir suivre au moins une courbure A selon un axe de courbure et ainsi répondre à la forme courbée du dispositif lumineux 1. On notera que la forme courbée du dispositif lumineux 1 est réalisé pour répondre à des besoins esthétiques.

Dans l'exemple non limitatif illustré sur les figures, l'axe de courbure est l'axe longitudinal au substrat rigide 120. Le substrat rigide 120 présente ainsi une épaisseur suffisamment petite pour offrir une flexibilité pour obtenir une courbure A. La courbure A est obtenue par cintrage du substrat rigide 120. Cependant son épaisseur est également suffisante pour assurer sa solidité. Dans un exemple de réalisation non limitatif, le substrat rigide 120 comprend une épaisseur sensiblement comprise entre 0.3mm et 1.6mm.

On notera que le substrat rigide 120 subit des contraintes mécaniques dues à sa forme courbée.

On notera que le substrat rigide 120 est rigide en ce qu'il ne nécessite pas de support de soutien pour conserver sa forme après cintrage, à savoir sa forme courbée.

Le substrat rigide 120 comprend :
- au moins une languette primaire 121 sur laquelle est disposée ladite au moins une source lumineuse 10 ;
- au moins une languette secondaire 122 sur laquelle est disposée ledit au moins un composant électronique de pilotage 11, ladite languette primaire 121 étant différente de ladite languette secondaire 122.

Dans un mode de réalisation non limitatif illustré sur les figures 2a à 9, le substrat rigide 120 comprend une pluralité de languettes primaires 121 et une pluralité de languettes secondaires 122.

Cela permet de disposer les composants électroniques 10, 11 sur différentes languettes primaires 121 ou secondaires 122 de façon à répartir la génération de chaleur par lesdits composants électroniques 10, 11. Par ailleurs, cela permet que les contraintes mécaniques qui s'exercent sur le substrat rigide 120 ne s'exercent sur les composants électroniques 10, 11.

### ∘ Languettes primaires 121 et secondaires 122

Les languettes primaires 121 et secondaires 122 sont adaptées pour isoler les composants électroniques qui chauffent les uns des autres, en particulier les sources lumineuses 10 et les composants électroniques de pilotage 11. En outre elles évitent que les contraintes mécaniques subies par le substrat rigide 120 ne fragilisent les zones de fixation des sources lumineuses 10 et des composants électroniques de pilotage 11 sur le substrat rigide 120.

On notera qu'on peut avoir autant de languettes primaires 121 que de languettes secondaires 122 par exemple lorsqu'un composant électronique de pilotage 11 pilote l'alimentation électrique d'une seule source lumineuse 10, ou on peut avoir plus de languettes primaires 121 que de languettes secondaires 122 par exemple lorsqu'un composant électronique de pilotage 11 pilote l'alimentation électrique de plusieurs sources lumineuses 10.

Une languette primaire 121 ou secondaire 122 est une partie du substrat rigide 120 qui est découpée selon respectivement une ligne de découpe 1210, 1220.

La ligne de découpe 1210, 1220 part et finit de la base 1300 illustrée sur la figure 3 de la languette primaire 121 ou secondaire 122. La base 1300 forme la jonction entre une languette primaire 121 ou secondaire 122 et le substrat rigide 120. A l'endroit de la base 1300, la surface de la languette primaire 121 et secondaire 122 est tangente à la surface du substrat rigide 120 ce qui permet de n'avoir aucune contrainte mécanique sur la languette primaire 121 ou secondaire 122 du fait de la courbure A du substrat rigide 120. Ainsi, lorsque le substrat rigide 12 est courbé selon au moins un axe de courbure, les languettes primaires 121 et secondaires 122 dont la base 1300 est située sur la courbure A du substrat rigide 120 restent planes. Les languettes primaires 121 et secondaires 122 sont ainsi découplées du substrat rigide 120. Elles ne subissent pas la déformation du substrat rigide 120.

Dans un exemple non limitatif, la ligne de découpe 1210, 1220 est réalisée par poinçonnage, fraisage, découpe laser.

La ligne de découpe 1210, 1220 qui est une absence de matière dans le substrat rigide 120, empêche la propagation de la chaleur du composant électronique qui se trouve sur une languette primaire 121 ou secondaire 122 du substrat rigide 120. Elle sert ainsi de rupture de pont thermique entre les sources lumineuses 10 et les composants électroniques de pilotage 11. L'air environnant passe en effet au travers de la ligne de découpe 1210, 1220 séparant thermiquement ainsi les différentes composants électroniques 10, 11 qui chauffent, les uns des autres.

La ligne de découpe 1210, 1220 permet de bien isoler les composants électroniques 10, 11 générateurs de chaleur et permet ainsi de limiter l'influence thermique qu'ils pourraient avoir les uns sur les autres.

La largeur de la ligne de découpe 1210, 1220 est définie de sorte à permettre à l'air environnant de mieux circuler autour de la languette primaire 121 ou secondaire 122 et ainsi d'améliorer l'évacuation de la chaleur produite par les sources lumineuses 10 et les composants électroniques de pilotage 11 implantés sur lesdites languettes primaires 121 et secondaires 122. Cela permet une meilleure durabilité des sources lumineuses 10 et des composants électroniques de pilotage 11. Dans un mode de réalisation non limitatif, la largeur de découpe minimum est sensiblement comprise entre 1 et 2 mm (millimètres).

Ainsi, les languettes primaires 121 et secondaires 122 permettent de répartir au mieux la production de chaleur et évitent les points chauds qui diminuent la durée de vie des sources lumineuses 10 et des composants électroniques de pilotage 11.

Les languettes primaires 121 et secondaires 122 sont dimensionnées pour évacuer au mieux la chaleur générée par lesdits composants électroniques 10, 11. Elles sont dimensionnées de sorte à avoir une bonne dissipation thermique des composants électroniques 10, 11 qu'elles supportent.

De cette façon, il est possible de disposer sur le substrat rigide 120 les sources lumineuses 10 et les composants électroniques de pilotage 11 sur des languettes primaires 121 et secondaires 122 en fonction de la chaleur qu'ils produisent. Par exemple, pour un composant électronique 10, 11 qui dégage beaucoup de chaleur, on le positionnera sur une languette primaire 121 ou secondaire 122 plus grande que pour un composant électronique 10, 11 qui dégage moins de chaleur.

On notera que la rigidité et les dimensions des languettes primaires 121 et secondaires 122 leur permettent de supporter le poids des composants électroniques implantés dessus.

Par ailleurs, les dimensions des languettes primaires 121 et secondaires 122 sont également définies pour tenir compte des contraintes vibratoires qui peuvent leur être appliquées. Dans un mode de réalisation non limitatif non illustré, outre les sources lumineuses 10 et les composants électroniques de pilotage 11, les languettes primaires 121 et secondaires 122 peuvent supporter d'autres composants électroniques qui ne chauffent pas ou très peu, par exemple des résistances, ces composants électroniques n'ayant pas d'impact sur les sources lumineuses 10 ou sur les composants électroniques de pilotage 11.

### ▪ Languette primaire 121

La languette primaire 121 est adaptée pour accueillir au moins une source lumineuse 10. Dans un mode de réalisation non limitatif, la languette primaire 121 accueille une seule source lumineuse 10 tel qu'illustré sur les figures 2a et 4 à 6. Dans un autre mode de réalisation non limitatif, la languette primaire 121 accueille une pluralité de sources lumineuses 10.

Dans un mode de réalisation non limitatif, la source lumineuse 10 est collée ou soudée sur ladite languette primaire 121.

Tel qu'illustré sur l'exemple non limitatif des figures, les languettes primaires 121 sont alignées selon l'axe longitudinal du substrat rigide 120. Dans l'exemple non limitatif de la figure 2a, l'axe longitudinal est l'axe longitudinal médian du substrat rigide 10. Dans un mode de réalisation non limitatif, les sources lumineuses 10 émettent des rayons lumineux R dans une direction d'émission principale sensiblement parallèle au plan des languettes primaires 121 tel qu'illustré sur les figures 4 à 6 et 9. Les rayons lumineux R comprennent une direction d'émission principale qui grâce à la courbure A du substrat rigide 120 se situe au-dessus des sources lumineuses 10 en amont. Une source lumineuse 10 ne gêne ainsi pas l'émission des rayons lumineux R d'une autre source lumineuse 10.

### ▪ Languette secondaires 122

La languette secondaire 122 est adaptée pour accueillir au moins un composant électronique de pilotage 11. Dans un mode de réalisation non limitatif, la languette secondaire 122 accueille un seul composant électronique de pilotage 11 tel qu'illustré sur les figures 2a et 4 à 6. Dans un autre mode de réalisation non limitatif, la languette secondaire 122 accueille une pluralité de composants électroniques de pilotage 11.

Dans un mode de réalisation non limitatif, le composant électronique de pilotage 11 est collé ou soudé sur ladite languette secondaire 122.

On notera que les composants électroniques de pilotage 11 sont disposés dans une zone morte, à savoir une zone non éclairée par les rayons lumineux R des sources lumineuses 10.

La languette primaire 121 et la languette secondaire 122 sont réalisées selon deux modes de réalisation non limitatifs décrits ci-dessous.

### ▪ Premier mode de réalisation

Tel qu'illustré sur les figures 3, 5, 7, la languette primaire 121 et/ou la languette secondaire 122 comprend respectivement une ligne de découpe 1210, 1220 comprenant chacune trois côtés 1211, 1212, 1213 et 1221, 1222, 1223 qui sont à distance de la périphérie 123 dudit substrat rigide 120.

Dans des variantes de réalisation non limitatives, la ligne de découpe 1210, 1220 est :
- en forme de U (tel qu'illustrée sur la figure 7a). La forme en U comprend des segments droits qui forment un angle β droit deux à deux ; ou
- en forme de trapèze dépourvu d'une de ses bases (tel qu'illustrée sur la figure 7b) ; ou
- en forme courbée (tel qu'illustrée sur la figure 7c). Dans une variante de réalisation non limitative illustrée, la forme courbée est un arc de cercle.

On notera que la forme en trapèze permet d'avoir un plus grand nombre de languettes primaires 121 ou secondaires 122 selon un même sens sur une même surface du substrat rigide 120 que la forme en U.

### ▪ Deuxième mode de réalisation

Tel qu'illustré sur les figures 3, 4, 6, 8, la languette primaire 121 et/ou la languette secondaire 122 comprend respectivement une ligne de découpe 1210, 1220 dont un côté 1211, 1221 est confondu avec la périphérie 123 dudit substrat rigide 120.

Cela permet de gagner la largeur d'une découpe et d'avoir un espace minimum avec une languette adjacente. Ainsi, on peut avoir une platine support 12 plus petite en largeur.

Dans des variantes de réalisation non limitatives, la ligne de découpe 1210, 1220 est :
- avec des segments droits (tel qu'illustrée sur les figure8a et 8b). Les segments droits sont contigus et forment un angle β entre eux. L'angle β est obtus, aigu (figure 8b) ou droit (figure 8a).
- en forme courbée (tel qu'illustrée sur la figure 8c). Dans une variante de réalisation non limitative illustrée, la forme courbée est un arc de cercle.

La languette primaire 121 et la languette secondaire 122 sont agencées selon différentes combinaisons du premier mode et du deuxième mode de réalisation non limitatifs présentés ci-dessous.

Ainsi, on peut avoir :
- des languettes primaires 121 et des languettes secondaires 122 selon le premier mode de réalisation non limitatif (figure 5) ;
- des languettes primaires 121 et des languettes secondaires 122 selon le deuxième mode de réalisation non limitatif (figure 6). Dans ce cas, on optimise la compacité de la platine support 12 puisqu'il n'existe aucune languette au centre et que des languettes au bord avec un bord confondu avec la périphérie 123 du substrat rigide 120 ;
- des languettes primaires 121 selon le premier mode de réalisation non limitatif et des languettes secondaires 122 selon le deuxième mode de réalisation non limitatif (figure 2a) ;
- des languettes secondaires 122 selon le premier mode de réalisation non limitatif et des languettes primaires121 selon le deuxième mode de réalisation non limitatif (figure 4).

Tel qu'illustré sur les figures 2a, et 3 à 6, dans un mode de réalisation non limitatif, la languette primaire 121 et la languette secondaire 122 sont décalées l'une de l'autre. Dans l'exemple non limitatif, elles sont décalées transversalement. Ainsi, tel qu'illustré sur la figure 3, l'axe de la base 1300 d'une languette secondaire 122 ne passe pas par une languette primaire 121 adjacente, et l'axe de la base 1300 d'une languette primaire 121 ne passe pas par une languette secondaire 121 adjacente. Cette disposition permet un gain de place et par conséquent de réduire la taille de la platine support 12 ou de mettre plus de composants électroniques 10, 11. La disposition en décalé de la languette primaire 121 et de la languette secondaire 122 forme ainsi un motif pouvant être répété n fois. Ainsi, le substrat rigide 120 peut comporter plusieurs alignements de languettes primaires 121 et secondaires 122 décalées les unes des autres.

Dans un autre mode de réalisation non limitatif illustré sur la figure 9, la languette primaire 121 et la languette secondaire 122 sont disposées côte à côté. Ainsi, tel qu'illustré sur la figure 9, l'axe de la base 1300 d'une languette secondaire 122 passe par une languette primaire 121 adjacente, et l'axe de la base 1300 d'une languette primaire 121 passe par une languette secondaire 121 adjacente. La disposition côte à côte de la languette primaire 121 et de la languette secondaire 122 forme ainsi un motif pouvant être répété n fois. Ainsi, le substrat rigide 120 peut comporter plusieurs alignements de languettes primaires 121 et secondaires 122 côte à côte.

On notera que le premier mode (trois côtés) et le deuxième mode (un côté confondu avec la périphérie 123) de réalisation non limitatifs des figures 4 à 6 s'appliquent à des languettes primaires 121 et secondaires 122 de la figure 9.

Bien entendu, la description de l'invention n'est pas limitée aux modes de réalisation décrits ci-dessus. Ainsi, dans un autre mode de réalisation non limitatif, les rayons lumineux R des sources lumineuses 10 peuvent être dans des directions différentes de celle parallèle ou perpendiculaire au plan des languettes primaires 121. Ainsi, dans un autre mode de réalisation non limitatif, le dispositif lumineux 1 est un dispositif d'éclairage intérieur pour véhicule automobile.

Ainsi, dans un autre mode de réalisation non limitatif, la platine support 12 et donc le substrat rigide 120 présente une courbure A selon un axe transversal et non pas longitudinal. Dans ce cas, les languettes primaires 121 et/ou secondaires 122 selon le deuxième mode de réalisation non limitatif sont construites le long d'un autre bord perpendiculaire au premier bord décrit précédemment. Dans ce cas, les languettes primaires 121 et/ou secondaires 122 selon le premier mode de réalisation sont tournées de 90° par rapport à celles illustrées sur les figures 1 à 7. Dans ce cas, selon un mode de réalisation non limitatif, une languette primaire 121 et/ou secondaire 122 peut être formée de deux segments droits disjoints disposés l'un en regard de l'autre, la périphérie du substrat rigide 120 formant un bord de la languette primaire 121 et/ou secondaire 122.

Ainsi, l'invention décrite présente notamment les avantages suivants :
- elle permet d'avoir un gain en largeur de platine support 12 grâce à une languette primaire 121 ou secondaire 122 dont un bord est confondu avec la périphérie 123 du substrat rigide 120 ;
- elle permet grâce aux languettes primaires 121 et secondaires 122 de se libérer des contraintes mécaniques et de mieux répartir les contraintes thermiques. Ainsi une languette primaire 121 ou secondaire 122 n'accueille pas toute la chaleur puisque les sources lumineuses 10 et les composants électroniques de pilotage 11 sont répartis sur différentes languettes primaires 121 et secondaires 122 ;
- elle évite que la chaleur dégagée par une source lumineuse 10 n'impacte un composant électronique de pilotage 11 et vice et versa grâce à la disposition sur des languettes différentes (et non sur une même languette comme dans le cas de l'état de la technique antérieur). Les performances des sources lumineuses 12 et des composants électroniques de pilotage 11 ne sont ainsi pas dégradées ;
- elle évite aux composants électroniques de pilotage 11 d'occulter les rayons lumineux R des sources lumineuses 12, ce qui est le cas s'ils se trouvent sur la même languette que les sources lumineuses 10. La quantité de lumière n'est ainsi pas diminuée ;
- elle permet de libérer de la place sur une languette primaire 121 pour d'autres sources lumineuses 10 si besoin est, puisque que les composants électroniques de pilotage 11 sont sur des languettes différentes, à savoir sur les languettes secondaires 12.

## Revendications

1. Dispositif lumineux (1) pour véhicule automobile, ledit dispositif lumineux (1) comprenant :
- au moins une source lumineuse (10) ;
- au moins un composant électronique de pilotage (11) de l'alimentation électrique de ladite au moins une source lumineuse (10) ;
- une platine support (12) comprenant un substrat (120) rigide avec :
- une languette primaire (121) sur laquelle est disposée ladite au moins une source lumineuse (10) ;
- une languette secondaire (122) sur laquelle est disposé ledit au moins un composant électronique de pilotage (11), ladite languette secondaire (122) étant différente de ladite languette primaire (121)
ledit substrat (120) présentant une courbure (A), ladite languette primaire (121) et ladite languette secondaire (122) présentant une ligne de découpe (1210, 1220) qui part et finit d'une base (1300), la base (1300) formant la jonction entre une languette primaire (121) ou secondaire (122) et le substrat rigide (120), la surface de la languette primaire (121) et secondaire (122) étant tangente à la surface du substrat rigide (120) à l'endroit de la base (1300).

2. Dispositif lumineux (1) selon la revendication 1, dans lequel la languette primaire (121) et/ou la languette secondaire (122) comprend une ligne de découpe (1210, 1220) dont un côté (1211, 1221) est confondu avec la périphérie (123) dudit substrat (120).

3. Dispositif lumineux (1) selon la revendication 2, dans lequel la languette primaire (121) et/ou la languette secondaire (122) comprend une ligne de découpe (1210, 1220) :
- avec des segments droits ; ou
- en forme courbée.

4. Dispositif lumineux (1) selon la revendication 1, dans lequel la languette primaire (121) et/ou la languette secondaire (122) comprend une ligne de découpe (1200, 1210) comprenant trois côtés (1201, 1202, 1203 et 1211, 1212, 1213) qui sont à distance de la périphérie (123) dudit substrat (120).

5. Dispositif lumineux (1) selon la revendication 4, dans lequel la languette primaire (121) et/ou la languette secondaire (122) comprend une ligne de découpe (1210, 1220) :
- en forme de U ; ou
- en forme de trapèze dépourvu d'une de ses bases ; ou
- en forme courbée.

6. Dispositif lumineux (1) selon l'une quelconque des revendications précédentes 1 à 5, dans lequel la languette primaire (121) et la languette secondaire (122) sont décalées l'une de l'autre.

7. Dispositif lumineux (1) selon l'une quelconque des revendications précédentes 1 à 5, dans lequel la languette primaire (121) et la languette secondaire (122) sont disposées côte à côte.

8. Dispositif lumineux (1) selon l'une quelconque des revendications précédentes 1 à 7, dans lequel ledit dispositif lumineux (1) comprend une pluralité de languettes primaires (121) et une pluralité de languettes secondaires (122).

9. Dispositif lumineux (1) selon l'une quelconque des revendications précédentes 1 à 8, dans lequel ladite au moins une source lumineuse (10) est une source lumineuse à semi-conducteur.

10. Dispositif lumineux (1) selon la revendication 9, dans lequel ladite source lumineuse à semi-conducteur (10) fait partie d'une diode électroluminescente.

11. Dispositif lumineux (1) selon l'une quelconque des revendications précédentes 1 à 10, dans lequel ledit dispositif lumineux (1) est adapté pour réaliser une fonction d'éclairage et/ou de signalisation.

12. Dispositif lumineux (1) selon l'une quelconque des revendications précédentes 1 à 11, dans lequel ledit dispositif lumineux (1) est un projecteur avant ou un feu arrière.

13. Dispositif lumineux (1) selon l'une quelconque des revendications précédentes 1 à 12, dans lequel ledit dispositif lumineux (1) est :
- un clignotant (TI) ; et/ou
- un feu diurne (DRL) ; et/ou
- un feu de parking (PL) ; et/ou
- un feu de position (TAIL) ; et/ou
- un feu d'arrêt (STP) ; et/ou
- un feu de recul (R) ; et/ou
- un feu de brouillard (FG) ; et/ou
- un feu latéral (SM) ; et/ou
- un troisième feu de stop (CHMSL).

## Patentansprüche

1. Leuchtvorrichtung (1) für ein Kraftfahrzeug, wobei die Leuchtvorrichtung (1) umfasst:
- wenigstens eine Lichtquelle (10);
- wenigstens eine elektronische Steuerungskomponente (11) für die Stromversorgung der wenigstens einen Lichtquelle (10);
- eine Tragplatte (12), die ein starres Substrat (120) umfasst, mit:
- einer primären Lasche (121), auf welcher die wenigstens eine Lichtquelle (10) angeordnet ist;
- einer sekundären Lasche (122) auf welcher die wenigstens eine elektronische Steuerungskomponente (11) angeordnet ist, wobei die sekundäre Lasche (122) von der primären Lasche (121) verschieden ist,
wobei das Substrat (120) eine Krümmung (A) aufweist, wobei die primäre Lasche (121) und die sekundäre Lasche (122) eine Schnittlinie (1210, 1220) aufweisen, welche an einer Grundlinie (1300) beginnt und endet, wobei die Grundlinie (1300) die Verbindungsstelle zwischen einer primären (121) oder sekundären (122) Lasche und dem starren Substrat (120) bildet, wobei die Flächen der primären (121) und der sekundären (122) Lasche am Ort der Grundlinie (1300) tangential zur Fläche des starren Substrats (120) sind.

2. Leuchtvorrichtung (1) nach Anspruch 1, wobei die primäre Lasche (121) und/oder die sekundäre Lasche (122) eine Schnittlinie (1210, 1220) umfassen, deren eine Seite (1211, 1221) mit dem Umfang (123) des Substrats (120) zusammenfällt.

3. Leuchtvorrichtung (1) nach Anspruch 2, wobei die primäre Lasche (121) und/oder die sekundäre Lasche (122) eine Schnittlinie (1210, 1220) umfassen:
- mit geraden Segmenten; oder
- in gekrümmter Form.

4. Leuchtvorrichtung (1) nach Anspruch 1, wobei die primäre Lasche (121) und/oder die sekundäre Lasche (122) eine Schnittlinie (1200, 1210) umfassen, die drei Seiten (1201, 1202, 1203 und 1211, 1212, 1213) umfasst, welche sich in einem Abstand vom Umfang (123) des Substrats (120) befinden.

5. Leuchtvorrichtung (1) nach Anspruch 4, wobei die primäre Lasche (121) und/oder die sekundäre Lasche (122) eine Schnittlinie (1210, 1220) umfassen:
- in Form eines "U"; oder
- in Form eines Trapezes, dessen eine Grundlinie fehlt; oder
- in gekrümmter Form.

6. Leuchtvorrichtung (1) nach einem der vorhergehenden Ansprüche 1 bis 5, wobei die primäre Lasche (121) und die sekundäre Lasche (122) zueinander versetzt sind.

7. Leuchtvorrichtung (1) nach einem der vorhergehenden Ansprüche 1 bis 5, wobei die primäre Lasche (121) und die sekundäre Lasche (122) nebeneinander angeordnet sind.

8. Leuchtvorrichtung (1) nach einem der vorhergehenden Ansprüche 1 bis 7, wobei die Leuchtvorrichtung (1) mehrere primäre Laschen (121) und mehrere sekundäre Laschen (122) umfasst.

9. Leuchtvorrichtung (1) nach einem der vorhergehenden Ansprüche 1 bis 8, wobei die wenigstens eine Lichtquelle (10) eine Halbleiterlichtquelle ist.

10. Leuchtvorrichtung (1) nach Anspruch 9, wobei die Halbleiterlichtquelle (10) Teil einer Leuchtdiode ist.

11. Leuchtvorrichtung (1) nach einem der vorhergehenden Ansprüche 1 bis 10, wobei die Leuchtvorrichtung (1) dafür eingerichtet ist, eine Beleuchtungs- und/oder Signalisierungsfunktion zu erfüllen.

12. Leuchtvorrichtung (1) nach einem der vorhergehenden Ansprüche 1 bis 11, wobei die Leuchtvorrichtung (1) ein Frontscheinwerfer oder eine Schlussleuchte ist.

13. Leuchtvorrichtung (1) nach einem der vorhergehenden Ansprüche 1 bis 12, wobei die Leuchtvorrichtung (1) ist:
- eine Blinkleuchte (TI); und/oder
- eine Tagfahrleuchte (DRL); und/oder
- eine Parkleuchte (PL); und/oder
- eine Begrenzungsleuchte (TAIL); und/oder
- eine Bremsleuchte (STP); und/oder
- ein Rückfahrscheinwerfer (R); und/oder
- eine Nebelleuchte (FG); und/oder
- eine Seitenmarkierungsleuchte (SM); und/oder
- eine dritte Bremsleuchte (CHMSL).

## Claims

1. Light device (1) for a motor vehicle, said light device (1) comprising:
- at least one light source (10);
- at least one electronic component (11) for driving the electrical power supply of said at least one light source (10);
- a support plate (12) comprising a rigid substrate (120) with:
- a primary tongue (121) on which said at least one light source (10) is disposed;
- a secondary tongue (122) on which said at least one electronic driving component (11) is disposed, said secondary tongue (122) being different from said primary tongue (121), said substrate (120) having a curvature (A), said primary tongue (121) and said secondary tongue (122) having a cutting line (1210, 1220) which starts and ends with a base (1300), the base (1300) forming the junction between a primary tongue (121) or secondary tongue (122) and the rigid substrate (120), the surface of the primary tongue (121) and secondary tongue (122) being tangential to the surface of the rigid substrate (120) at the point of the base (1300).

2. Light device (1) according to Claim 1, wherein the primary tongue (121) and/or the secondary tongue (122) comprises a cutting line (1210, 1220) of which one side (1211, 1221) coincides with the periphery (123) of said substrate (120).

3. Light device (1) according to Claim 2, wherein the primary tongue (121) and/or the secondary tongue (122) comprises a cutting line (1210, 1220):
- with straight segments; or
- in curved form.

4. Light device (1) according to Claim 1, wherein the primary tongue (121) and/or the secondary tongue (122) comprises a cutting line (1200, 1210) comprising three sides (1201, 1202, 1203 and 1211, 1212, 1213) which are at a distance from the periphery (123) of said substrate (120).

5. Light device (1) according to Claim 4, wherein the primary tongue (121) and/or the secondary tongue (122) comprises a cutting line (1210, 1220):
- in the form of a U; or
- in the form of a trapezium without one of its bases; or
- in curved form.

6. Light device (1) according to any one of the preceding Claims 1 to 5, wherein the primary tongue (121) and the secondary tongue (122) are offset from one another.

7. Light device (1) according to any one of the preceding Claims 1 to 5, wherein the primary tongue (121) and the secondary tongue (122) are disposed side-by-side.

8. Light device (1) according to any one of the preceding Claims 1 to 7, wherein said light device (1) comprises a plurality of primary tongues (121) and a plurality of secondary tongues (122).

9. Light device (1) according to any one of the preceding Claims 1 to 8, wherein said at least one light source (10) is a semiconductor light source.

10. Light device (1) according to Claim 9, wherein said semiconductor light source (10) forms part of a light-emitting diode.

11. Light device (1) according to any one of the preceding Claims 1 to 10, wherein said light device (1) is adapted to perform a lighting and/or signalling function.

12. Light device (1) according to any one of the preceding Claims 1 to 11, wherein said light device (1) is a front headlight or a rear light.

13. Light device (1) according to any one of the preceding Claims 1 to 12, wherein said light device (1) is:
- an indicator light (TI); and/or
- a daytime running light (DRL); and/or
- a parking light (PL); and/or
- a position light (TAIL); and/or
- a stop light (STP); and/or
- a reversing light (R); and/or
- a fog light (FG); and/or
- a side marker light (SM); and/or
- a third brake light (CHMSL).
